# EUROPEAN PATENT SPECIFICATION

(11) **EP 2 374 914 B1**
(45) Date of publication and mention of the grant of the patent: **22.07.2015**
(21) Application number: 10159259.0
(22) Date of filing: 07.04.2010
(51) Int. Cl.: C23C 14/56, B29C 37/00, F16K 7/10, H01J 37/18

(54) **A device for sealing a chamber inlet or a chamber outlet for a flexible substrate; substrate processing apparatus, and method for assembling such a device**
Vorrichtung zum Abdichten von einem Kammereinlass oder einem Kammerauslass für ein flexibles Substrat, Substratverarbeitungsvorrichtung und Verfahren zur Anordnung solch einer Vorrichtung
Dispositif pour sceller une entrée de chambre ou une sortie de chambre pour un substrat flexible, appareil de traitement de substrat et procédé d'assemblage d'un tel dispositif

(43) Date of publication of application: 12.10.2011
(73) Proprietor: Applied Materials, Inc., Santa Clara, CA 95054 (US)
(72) Inventor: Wenk, Karl-Heinrich, 61231 Bad Nauheim (DE); Hacker, Volker, 63674 Altenstadt-Oberau (DE)
(74) Representative: Zimmermann & Partner Patentanwälte mbB

(56) References cited:
- DD-A5- 285 120
- DE-A1- 19 960 751
- US-A- 3 170 576
- US-A- 3 891 223
- US-A- 4 249 846
- US-A- 4 812 101
- US-A- 5 254 169
- US-A1- 2007 107 781

## Description

The present disclosure relates to a device for sealing a chamber inlet or a chamber outlet for a flexible substrate. In particular, the present disclosure relates to a device having a body and a substrate opening formed in the body.

Further, the present disclosure relates to a substrate processing apparatus for processing a flexible substrate, the substrate processing apparatus including a first chamber and a second chamber separated from the first chamber.

Additionally, the present disclosure relates to a method for assembling a device for sealing a chamber inlet or a chamber outlet for a flexible substrate.

### BACKGROUND

In many applications, it is necessary to deposit thin layers on a flexible substrate.

Typically, the flexible substrates are coated in different chambers of a flexible substrate coating apparatus. Further, a stock of a flexible substrate, for example, a roll of a flexible substrate, may be disposed in one chamber of the substrate coating apparatus. Typically, the flexible substrates are coated in a vacuum, using a vapour deposition technique, for example, physical vapour deposition or chemical vapour deposition. However, for repairing or exchanging some devices in the chambers, or for refilling or restocking the stock of flexible substrate, at least one of the chambers may be pressurised to atmosphere pressure, such that a person may access the chamber or the stock of flexible substrate may be refilled or retrieved. In other examples, the stock of flexible substrate may remain in vacuum when a deposition apparatus has to be serviced, for example, a target of a sputtering apparatus needs to be changed. However, other chambers of the substrate coating apparatus may still remain evacuated. For these purposes, a chamber may be sealed from another chamber, in particular when the flexible substrate is traversing a wall between two chambers.

Thus, it is possible that one chamber has a very low pressure, while the other chamber has a relative high pressure, even when the flexible substrate is traversing the wall between the two chambers.

US 2007/0107781 A1 discloses an air-lock valve provided for closing a gap-like opening, traversed by a flexible band substrate, between two different plant sections, featuring at least one moveable sealing body, cooperating with a sealing surface, when it closes said opening, the sealing surface surrounding opening in frame-like fashion, and in order to close opening, said body may be pressed in such a fashion upon sealing surface and/or upon band substrate, traversing said opening, that it obstructs said opening; at least due to indirect juxtaposition at the edges of said sealing surface.

US 4,812,101 concerns a method and apparatus for continuous introduction and exit of workpieces into and out of a vacuum. A first seal is provided between the atmosphere and a first pumping station. This seal comprises compliant members positioned within cavities in a plate so that the pressure differential causes the members to push against the workpiece and the cavity wall to establish a rotating seal. A second seal may also be provided between the first pumping station and the vacuum chamber. This seal includes compliant members mounted within a series of differentially pumped cavities and providing a low friction seal with the workpiece.

US 3,170,576 concerns a seal unit comprising a housing, first and second rollers rotatably supported at their ends by said housing, said rollers being tangent to each other and in rolling engagement with each other, said second roller including: a plurality of discrete segments disposed side by side, an elastic sleeve maintaining said segments, in such side by side/disposition, and. means for evacuating the interior of said second roller and the space around the ends of said first roller.

US 3,891,223 describes a sealing system for sealing the inlet and outlet slots of treatment containers, especially for widths of textile goods. The system includes two sealing beads which form a portion of two inflatable hoses closed at their ends and normally held in cylindrical rims or housing members which are arranged adjacent and parallel to each other and at their adjacent portions are provided with slotted sections bridged by the sealing beads. The sealing beads are respectively surrounded by flexible foils of wear-resistant material, which foils are adapted to be detachably clamped between the cylindrical rims and the pertaining hoses.

### SUMMARY

In the light of the above, a device for sealing a chamber inlet according to claim 1, a substrate processing apparatus according to claim 9, and a method according to claim 10 are provided.

In light of the above, a device for sealing a chamber inlet or a chamber outlet for a flexible substrate is provided, including a body having a sealing surface, a substrate opening formed in the body configured to be traversed by the flexible substrate, an elastic tube at least partially facing the sealing surface, wherein the elastic tube is adapted for inflating and deflating during operation, a rigid bar disposed within the elastic tube, wherein the rigid bar is a rigid tube, wherein the elastic tube is maintained by the rigid bar in a fixed position in the device, wherein the interior of the rigid tube is configured to be connected to a gas supply, and the interior of the rigid tube is in fluid connection with a space between the rigid tube and the elastic tube, such that the elastic tube has a connecting portion for connecting the gas supply.

In a typical embodiment, which may be combined with other embodiments disclosed herein, the device further includes a recess formed in the body opposite to the sealing surface, wherein in particular the recess is substantially U-shaped or has a substantial semi-circular cross-section in a section orthogonal to a longitudinal axis of the elastic tube.

In a typical embodiment, which may be combined with other embodiments disclosed herein, the recess has in particular the form of a groove.

For example, in an embodiment, the recess has a longitudinal axis substantially parallel to the longitudinal axis of the elastic tube.

In a typical embodiment, which may be combined with other embodiments disclosed herein, the elastic tube is arranged at least partially in the recess.

For example, in an embodiment, the sealing surface is formed in the substrate opening.

In a typical embodiment, which may be combined with other embodiments disclosed herein, the longitudinal axis of the elastic tube is substantially orthogonal to the transport direction of the flexible substrate.

In a typical embodiment, the rigid bar may be fabricated of a metal, for example, steel. In a typical embodiment, the rigid bar is in the form of a rigid tube.

For example, in an embodiment, the body includes at least one tube mounting opening extending the recess in direction of the longitudinal axis of the recess for mounting at least one element selected of the group consisting of the elastic tube and the rigid bar.

In a typical embodiment, which may be combined with other embodiments disclosed herein, the at least one tube mounting opening has a circumferential tube mounting opening sealing surface, wherein the elastic tube is pressed against the tube mounting opening sealing surface, such that a fluid flow in the direction through the at least one tube mounting opening is prevented, wherein in particular the supply opening sealing surface is substantially conical.

In a typical embodiment, which may be combined with other embodiments disclosed herein, the device further includes at least one plug disposed respectively in a tube mounting opening, wherein the plug presses the elastic tube against the mounting opening sealing surface, wherein in particular the at least one plug is substantially conical.

In a typical embodiment, the plug is adapted to the mounting opening sealing surface.

For example, in an embodiment, the at least one plug maintains the rigid bar, in particular the rigid tube.

In a typical embodiment, which may be combined with other embodiments disclosed herein, the at least one plug includes a fluid channel for connecting the interior of the elastic tube to at least one source selected of a group consisting of a pressure source and a vacuum source.

For example, in an embodiment, when in an inflated state, a portion of the elastic tube is pressed against the surface of the recess facing the substrate opening sealing surface.

According to a further aspect, a substrate processing apparatus for processing a flexible substrate is provided, the substrate processing apparatus including a first chamber and a second chamber separated from the first chamber, and a device according to an embodiment disclosed herein, wherein the device selectively opens or closes a fluid connection between the first and the second chamber.

In a typical embodiment, which may be combined with other embodiments disclosed herein, the device is provided in a wall between the first chamber and the second chamber.

According to a further aspect, a method for assembling a device for sealing a chamber inlet or a chamber outlet for a flexible substrate is provided, including: providing a body having a sealing surface, wherein a substrate opening is formed in the body configured to be traversed by the flexible substrate; inserting an elastic tube into the body, such that the elastic tube is at least partially facing the sealing surface, the elastic tube having a connecting portion and being adapted for inflating and deflating during operation; arranging the elastic tube around a rigid bar, wherein the rigid bar is a rigid tube, wherein the elastic tube is maintained by the rigid bar in a fixed position in the device; and connecting the interior of the rigid tube to a gas supply such that the connecting portion of the elastic tube is connected to the gas supply. According to a further aspect, the device further includes a recess formed in the body opposite to the sealing surface, wherein the method includes inserting the elastic tube at least partially into the recess.

For example, in an embodiment, the body includes at least one tube supply opening extending the recess in the direction of its longitudinal axis, wherein the elastic tube is introduced into the recess through the tube supply opening.

In an embodiment, which may be combined with other embodiments disclosed herein, the method further includes: pressing the elastic tube against a circumferential tube supply opening sealing surface of the at least one tube supply opening, such that a fluid flow in the direction through the at least one tube supply opening is prevented.

In a typical embodiment, which may be combined with other embodiments disclosed herein, the sealing surface has a longitudinal axis and includes a central portion, in particular substantially parallel to the elastic tube or the longitudinal axis of the elastic tube. Further, the sealing surface may include a lateral portion at each longitudinal extremity of the sealing surface, and an intermediate portion between each lateral portion and the central portion, wherein in particular the elastic tube is permanently pressed against the lateral portions, in particular when the elastic tube is inflated or deflated.

For example, in an embodiment, the radius of curvature of the transition between the lateral portions and the respective adjacent intermediate portions is greater than 80 mm, in particular greater than 90 mm. For example, the radius of curvature may be between 90 mm and 120 mm.

In a typical embodiment, which may be combined with other embodiments disclosed herein, the radius of curvature of the transition between the central portion and the intermediate portions is respectively greater than 80 mm, in particular greater than 90 mm. For example, the radius of curvature may be between 90 mm and 120 mm.

For example, in an embodiment, the angle of a circular segment of the transition between the central portion and the intermediate portion is respectively smaller than 15 degrees, in particular less than 10 degrees. For example, the angle of the transition between the central portion and the intermediate portion is between 5 degrees and 10 degrees.

In a typical embodiment, which may be combined with other embodiments disclosed herein, the angle of a circular segment of the transition between the lateral portion and the respective adjacent intermediate portions is smaller than 15 degrees, in particular less than 10 degrees. For example, the angle of the transition between the lateral portion and the respective adjacent intermediate portion is between 5 degrees and 10 degrees.

For example, in an embodiment, the intermediate portions are between 5 percent and 15 percent of the extension of the opening in longitudinal extension of the sealing surface.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 shows schematically a sectional view of a wall including a device for sealing a chamber inlet or chamber outlet;
Fig. 2 shows schematically a traversal cross section B-B of Fig. 3 of a device for sealing a chamber inlet or chamber outlet;
Fig. 3 shows schematically a longitudinal cross section A-A of Fig. 2 of a device for sealing a chamber inlet or chamber outlet; and
Fig. 4 shows a flowchart of a method for assembling a device for sealing a chamber inlet or a chamber outlet.

### DETAILED DESCRIPTION OF THE EMBODIMENTS

Reference will now be made in detail to the various embodiments, one or more examples of which are illustrated in the figures. Each example is provided by way of explanation, and is not meant as a limitation of the invention. Within the following description of the drawings, the same reference numbers refer to the same components. Generally, only the differences with respect to the individual embodiments are described.

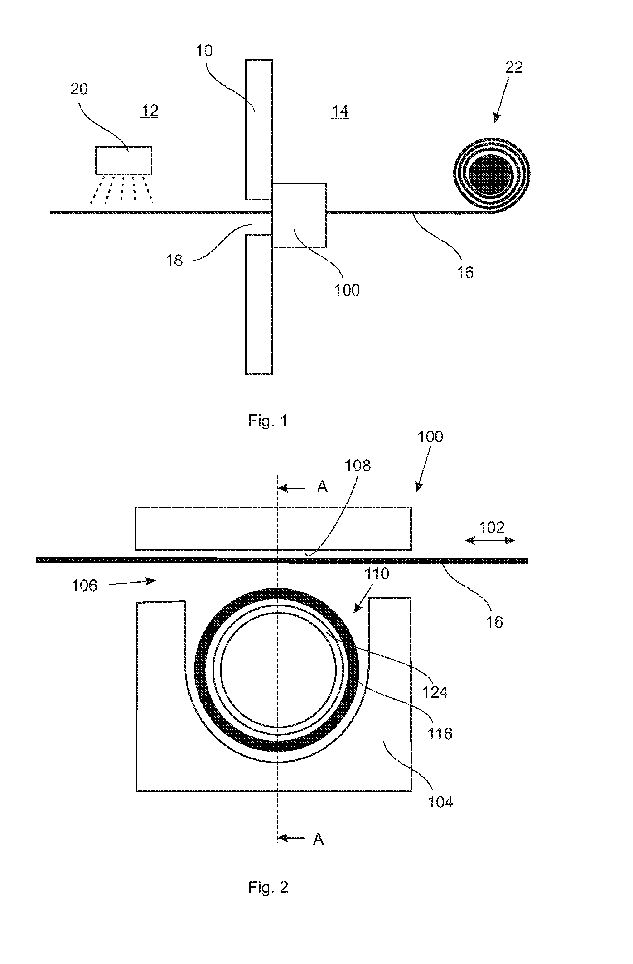

Fig. 1 shows schematically a side view of a cross section of a wall 10 between a first chamber 12 and a second chamber 14. In both chambers 12, 14, a flexible substrate 16 is processed. Typically, during processing, the chambers 12, 14 have a pressure of about 10⁻⁴ mbar or about 10⁻⁵ mbar. For example, in first chamber 12 the flexible substrate 16 may be coated by a coating device 20. In chamber 14, the flexible substrate may be rolled up or unrolled on a flexible substrate roll 22. Typically, the flexible substrate 16 traverses the wall 10 through a wall opening 18. The first chamber 12 and a second chamber 14 may have different pressures, for example, when the roll 22 is exchanged with a new roll 22. Then, the wall opening 18 may be sealed tightly, even if a portion of the flexible substrate 16 is traversing the wall opening 18.

For this purpose, a device for sealing a chamber inlet or chamber outlet 100 is disposed at or in the wall opening 18. The device 100 is traversed by the flexible substrate 16. In further embodiments, which may be combined with other embodiments disclosed herein, the device 100 may be integrated in the wall 10 or be a portion of the wall 10, so that the wall opening may correspond to a substrate opening of the device 100. In some embodiments, the device 100 is tightly fixed to the wall 10, for example, by screws or bolts.

Fig. 2 shows schematically a traversal cross section of the device 100. The device 100 includes a body 104 having a substrate opening 106 which is typically traversed by the flexible substrate 16 in a transport direction 102 of the flexible substrate. In a typical embodiment, which may be combined with other embodiments disclosed herein the body 104 is manufactured from a rigid material, typically a metal, e.g., steel or stainless steel. For example, in an embodiment, the body 104 may be manufactured from subassemblies, the subassemblies may then correspond respectively to a half of the body 104.

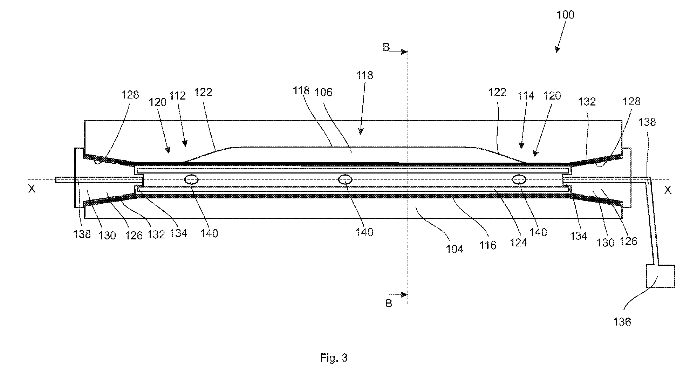

The substrate opening 106 has sealing surface 108, typically extending along the longitudinal direction of the device 100, and opposite to the sealing surface 108, a groove or a recess 110 is disposed. As can be seen in the longitudinal cross section of the device 100 shown in Fig. 3, the substrate opening 106 has a first end 112 and a second end 114 in the longitudinal direction X of the device 100. In Fig. 3, the device 100 is shown without a traversing flexible substrate.

In the recess 110, an elastic tube 116 is arranged. In a typical embodiment, the elastic tube 116 may be manufactured, from rubber, viton, silicone, and/or nitrile butadiene rubber (NBR). The elastic tube may be inflated, such that, in an embodiment, a portion of the surface of the elastic tube 116 is pressed against the sealing surface 108. In case the flexible substrate 16 is traversing the substrate opening 106, the inflated elastic tube is pressed against the flexible substrate 16.

Typically, the deflated elastic tube may have an outer diameter between about 25 mm and about 50 mm, in particular, between 30 mm and 45 mm. Further, the deflated elastic tube may have a thickness between 2 mm and about 8 mm, in particular between about 3 mm and about 7 mm.

In an embodiment, the elastic tube 116 exceeds the substrate opening 106 in longitudinal direction X. Thus, the longitudinal extension of elastic tube 116 is greater than the longitudinal extension of the substrate opening 106. In a typical embodiment, which may be combined with other embodiments disclosed herein, the elastic tube 116 may be inflated by a pressure source.

The sealing surface typically has a longitudinal axis substantially parallel to a longitudinal axis X of the device 100, which may coincide in an embodiment, which may be combined with other embodiments disclosed herein, with a longitudinal axis X of the elastic tube 116.

Typically, the recess 110 is substantially U-shaped in a traversal cross-section, such that the inflated elastic tube 116 may press tightly against the wall of the recess 110. In another embodiment, the recess 110 may be substantially half-circular or half-oval shaped in a traversal cross-section. In a typical embodiment, the traversal extension of the recess 110 corresponds substantially to the outer diameter of the deflated elastic tube 116. For example, the radius of the half-circular portion of the U-shaped cross section may have a radius corresponding to, or slightly exceeding, the external radius of the deflated elastic tube. For example, the radius of the half circular portion of the recess may exceed 5% of the outer radius of the deflated elastic tube. In another embodiment, the deflated elastic tube may be in contact with the wall of the recess. In an embodiment, which may be combined with other embodiments disclosed herein, the radius of the half circular portion of the recess may be between about 15 mm and about 30 mm, in particular about 20 mm.

Typically, a contiguous portion of the inflated elastic tube 116, the contiguous portion being in particular disposed along the longitudinal axis X, is pressed against the wall of the recess. Typically, the contiguous portion extends at least between the first end 112 and the second end 114 of the substrate opening 106. Thus, in case of an inflated elastic tube fluid communication between the first chamber 12 and the second chamber 14 passing through the recess is substantially prevented, even in the case of large pressure differences.

In a typical embodiment, which may be combined with other embodiments, a rigid tube 124 is disposed within the elastic tube 116, the rigid tube 124 having, in a typical embodiment, at least the length of the substrate opening 106. In a typical embodiment, the rigid tube 124 may have a length in longitudinal axis X of the device 100 exceeding the longitudinal extension of the substrate opening 106. Further, in an embodiment, the longitudinal extension of elastic tube 116 is greater than the longitudinal extension of the rigid tube 124. For example, in an embodiment, which may be combined with other embodiments disclosed herein, the rigid tube may have an outer diameter being slightly smaller, for example 5% to 20 % smaller, than the inner diameter of the deflated elastic tube. Hence, a space is formed between the deflated elastic tube and the rigid tube.

In some embodiments, a rigid bar, in particular a cylindrical rigid bar, may be disposed in the elastic tube 116. The rigid bar may be used in some embodiments instead of the rigid tube. Typically, the rigid tube may be an embodiment of the rigid bar. The rigid bar may have, in a typical embodiment, at least the length of the substrate opening 106. In a typical embodiment, the rigid bar may have a length in longitudinal axis X of the device exceeding the longitudinal extension of the substrate opening 106. In a typical embodiment, the longitudinal extension of elastic tube 116 is greater than the longitudinal extension of the rigid bar. For example, in an embodiment, which may be combined with other embodiments disclosed herein, the rigid bar may have an outer diameter being slightly smaller, for example 5% to 20 % smaller, than the inner diameter of the deflated elastic tube. Hence, a space is formed between deflated elastic tube and the rigid bar. Typically, the rigid bar is more rigid than the elastic tube. For example, the rigid bar may be fabricated of a metal, for example steel.

According to an embodiment of the invention, the rigid tube 124 and/or the rigid bar is maintained in a fixed position in the recess 110 of the device 100. Hence, the elastic tube 116 is maintained by the rigid tube or the rigid bar in a fixed position in the device 100. Thus, even in a deflated state, the elastic tube retracts into or in the direction of the recess, such that the deflated elastic tube 116 may not harm a flexible substrate 116 traversing the substrate opening 106. Thus, the deflated elastic tube 116 may not scratch the flexible substrate.

Typically, the rigid tube 124 or the rigid bar are more rigid than the elastic tube 116, in particular as they are adapted to maintain the deflated elastic tube in the recess. For example, the rigid tube may be fabricated of a metal, e.g. aluminium, stainless steel, or steel.

In a typical embodiment, which may be combined with other embodiments disclosed herein, the recess 110 is extended at each extremity 112, 114 of the opening in the direction of the longitudinal axis X by a tube mounting opening 126. The tube mounting opening 126 is used to insert the elastic tube 116 and the rigid tube 124 into the recess 110. Typically, the tube mounting openings 126 have respectively a lateral portion with a substantially conical surface 128. In a typical embodiment, which may be combined with other embodiments, the elastic tube is pressed by a plug 130 against the conical surface 128 of the tube mounting opening 126. In a typical embodiment, the plug 130 may have a circumferential protrusion 132, such that a fluid flow in the longitudinal direction of the recess through the tube mounting opening 126 is prevented. Further, the plug 130 may have, in an embodiment, a support protrusion 134 for supporting the rigid tube 124. Thus, the rigid tube 124 is fixed in its position in the recess 110. Typically, the plugs 130 are fixed, for example by a screw or a bolt, to the body 104 of the device 100.

The plug is further designed to provide a fluid connection 138 between a fluid supply 136 and an interior of the elastic tube 116. For example, each plug may have such a fluid connection 138. In a further embodiment, a first plug may be connected with a pump for evacuating or deflating the elastic tube, and the other fluid connection 138 may be connected with a pressure source 136. According to an embodiment of the invention, the fluid supply is connected to the interior of the rigid tube 124. For providing the pressure to the space between the rigid tube and elastic tube 116, the rigid tube may include openings 140 such that a fluid connection is possible between the interior of the rigid tube 124 and the space between the rigid tube 124 and the elastic tube 116. For example, elastic tube 116 may be inflated such that the interior of the inflated elastic tube 116 has a pressure of about 6 bar.

In some embodiments, the fluid connection 138 may be disposed, so that the compressed air is directly provided in the space between the rigid tube 124 and the elastic tube 116.

As the elastic tube 116 is mechanically and tightly pressed against the sealing surface of the tube mounting opening 126, the elastic tube 116 is typically not vulcanized or galvanized to the body 104. Hence, the elastic tube 116 is easily replaceable in the device 100.

In a typical embodiment, the sealing surface includes a central portion 118. In a typical embodiment, a lateral portion 120 is respectively disposed at each longitudinal extremity of the sealing surface 108. In some embodiments, the lateral portions 120 may be disposed, at least partially, in the tube mounting opening 126.

Further, the sealing surface 108 may include an intermediate portion 122 between each lateral portion and the central portion 118. Typically, the lateral portions 120 are disposed at a first end 112 and a second end 114 of the sealing surface 108. In a typical embodiment, the central portion and/or the lateral portions 120 is/are substantially parallel to the longitudinal axis X of the elastic tube 116 or the device 110.

Typically, there is a smooth transition between the central portion and the intermediate portions and between the intermediate portions and the respective lateral portions. For example, the radius of the cavity of the transitions between the lateral portion and the respective adjacent intermediate portions, or the intermediate portions and the central portion, may be greater than 80 mm, in particular greater than 90 mm. For example, the radius of curvature may be between 90 mm and 120 mm.

Further, circular segments of the transitions between the portions of the sealing surface may be smaller than 15 degrees, in particular less than 10 degrees. For example, the angle of the transition between the portions of the sealing surface may be between 5 degrees and 10 degrees.

Thus, even if the elastic tube is pressurized and presses the substrate against the sealing surface 108, a tight connection may be realized.

A device according to embodiments disclosed herein is extremely tight, such that a reliable separation of chambers having a different air pressure may be realized, even if a flexible substrate is present within the substrate opening. In particular, the robust and round tube design enables a high level of tightness.

Thus, in the case of an inflated elastic tube fluid communication between a first chamber and the second chamber is substantially prevented, even in the case of large pressure differences between the first chamber and the second chamber. For example, a chamber may be an unwinding or winding up chamber of a flexible substrate processing device, wherein the unwinding or winding up chamber is adjacent to a deposition chamber. According to an embodiment, the unwinding or winding up chamber may be sealed vacuum tight against the deposition chamber. Thus, for example, a target of a physical vapour deposition apparatus may be changed without exposing the flexible substrate in another chamber to the atmosphere, which may contain small particles.

Thus, the device 100 seals vacuum tight an opening between a first chamber and a second chamber, even if the flexible substrate is traversing the device 100. Typically, the flexible substrate does not harm the tightness of the device, even if it is present in the substrate opening. According to the embodiments disclosed, an elastic tube is disposed in a recess and may be pressurized with pressurized air, such that it is inflated and closes the opening for the flexible substrate. The elastic tube may only extend substantially in the direction of the sealing surface, so that the substrate is pressed against the facing sealing surface. In the open state, the elastic tube retracts into the recess and clears the substrate opening.

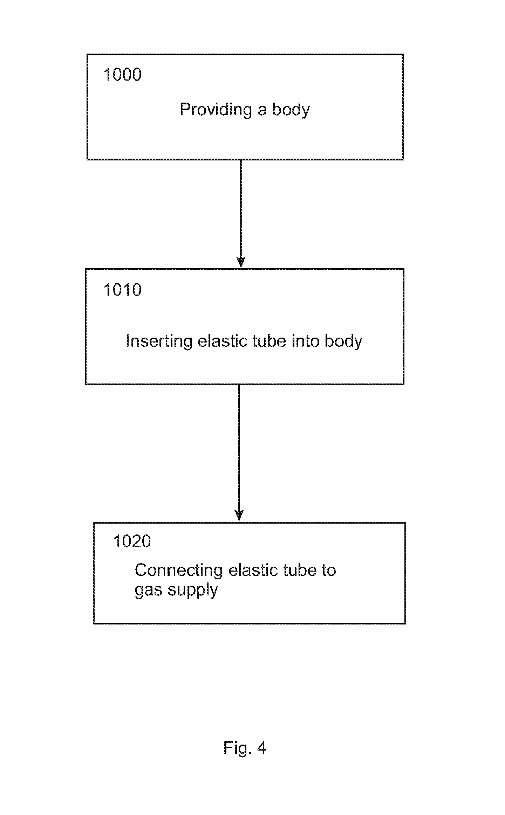

Fig. 4 shows a schematic drawing of a method for assembling a device for sealing a chamber inlet or a chamber outlet for a flexible substrate. In box 1000, a body is provided. The body has a sealing surface, and a substrate opening is formed in the body configured to be traversed by the flexible substrate. In a typical embodiment, a recess is formed in the body opposite the sealing surface. In box 1010, an elastic tube is inserted into the body, for example, in the recess of the body, such that the elastic tube is partially facing the sealing surface. For example, the elastic tube may be provided through a tube mounting opening provided in the body. In a further embodiment, a rigid tube may be provided in the elastic tube. Typically, in box 1020, the elastic tube, in particular the interior of the elastic tube, is connected to a gas supply, for example a pressurized air source. Thus, the elastic tube may be inflated for closing the substrate opening.

In a typical embodiment, the recess is substantially without corners. For example, a contiguous portion of the elastic tube, in particular extending between a first end of the substrate opening to a second end of the substrate opening, is pressed against the wall of the recess.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A device (100) for sealing a chamber inlet (18) or a chamber outlet for a flexible substrate (16), comprising
a body (104) having a sealing surface (108),
a substrate opening (106) formed in the body configured to be traversed by the flexible substrate,
an elastic tube (116) at least partially facing the sealing surface, wherein the elastic tube is adapted for inflating and deflating during operation,
a rigid bar (124) disposed within the elastic tube (116), wherein the rigid bar (124) is a rigid tube,
wherein the elastic tube (116) is maintained by the rigid bar (124) in a fixed position in the device (100), wherein the interior of the rigid tube is configured to be connected to a gas supply,
and the interior of the rigid tube is in fluid connection with a space between the rigid tube and the elastic tube, such that the elastic tube has a connecting portion for connecting the gas supply (136).

2. The device according to claim 1, further comprising
a recess (110) formed in the body opposite to the sealing surface, wherein in particular the recess (110) is substantially U-shaped or has a substantial semi-circular cross-section in a section orthogonal to a longitudinal axis of the elastic tube.

3. The device according to claim 2, wherein
the elastic tube (116) is arranged at least partially in the recess.

4. The device according to one of the preceding claims, wherein
the sealing surface (108) is formed in the substrate opening (106).

5. The device according to one of the claims 2 to 4, wherein
the body (104) comprises at least one tube mounting opening (126) extending the recess in the direction of the longitudinal axis (X) of the recess (110) for mounting at least one element selected of the group consisting of the elastic tube and the rigid bar.

6. The device according to claim 5, wherein
the at least one tube mounting opening (126) has a circumferential tube mounting opening sealing surface (128), wherein the elastic tube is pressed against the tube mounting opening sealing surface (128), such that a fluid flow in direction through the at least one tube mounting opening is prevented, wherein in particular the supply opening sealing surface is substantially conical.

7. The device according to claim 5 or 6, further comprising
at least one plug (130) disposed respectively in a tube mounting opening, wherein the plug presses the elastic tube (116) against the mounting opening sealing surface, wherein in particular the at least one plug is substantially conical.

8. The device according to claim 7, wherein
the at least one plug maintains the rigid bar (124).

9. A substrate processing apparatus for processing a flexible substrate, the substrate processing apparatus comprising
a first chamber (12) and a second chamber (14) separated from the first chamber, and a device according to one of the preceding claims, wherein
the device selectively opens or closes a fluid connection between the first and the second chamber.

10. The method for assembling a device for sealing a chamber inlet or a chamber outlet for a flexible substrate (16), comprising
providing a body (104) having a sealing surface (108), wherein a substrate opening (106) is formed in the body configured to be traversed by the flexible substrate; inserting an elastic tube (116) into the body, such that the elastic tube (116) is facing at least partially the sealing surface (108), the elastic tube having a connecting portion and being adapted for inflating and deflating during operation,
arranging the elastic tube around a rigid bar (124), wherein the rigid bar (124) is a rigid tube, wherein the elastic tube (116) is maintained by the rigid bar (124) in a fixed position in the device (100), and connecting the interior of the rigid tube to a gas supply such that the connecting portion of the elastic tube is connected to the gas supply (136).

11. The method according to claim 10, wherein
the device is further comprising a recess (110) formed in the body opposite to the sealing surface, wherein the method comprises
inserting the elastic tube (116) at least partially into the recess.

12. The method according to claim 11, wherein
the body comprises at least one tube supply opening (126) extending the recess in direction of its longitudinal axis, wherein the elastic tube is introduced in the recess through the tube supply opening.

13. The method according to claim 12, further comprising
pressing the elastic tube against a circumferential tube supply opening sealing surface (128) of the at least one tube supply opening, such that a fluid flow in direction through the at least one tube supply opening is prevented.

## Patentansprüche

1. Vorrichtung (100) zum Abdichten eines Kammereinlasses (18) oder eines Kammerauslasses für ein flexibles Substrat (16), Folgendes aufweisend einen Körper (104) mit einer Dichtfläche (108),
eine im Körper ausgebildete Substratöffnung (106), die dazu ausgelegt ist, vom flexiblen Substrat durchquert zu werden,
ein elastisches Rohr (116), das zumindest teilweise der Dichtfläche zugewandt ist, wobei
das elastische Rohr dazu angepasst ist, sich während des Betriebs aufzublähen und zu entleeren,
einen starren Stab (124), der im elastischen Rohr (116) angeordnet ist, wobei der starre Stab (124) ein starres Rohr ist,
wobei das elastische Rohr (116) mittels des starren Stabs (124) in einer festen Position in der Vorrichtung (100) gehalten ist, wobei das Innere des starren Rohrs dazu ausgelegt ist, an eine Gasversorgung angeschlossen zu werden,
und das Innere des starren Rohrs in Fluidverbindung mit einem Raum zwischen dem starren Rohr und dem elastischen Rohr steht, dass das elastische Rohr einen Anschlussabschnitt zum Anschließen der Gasversorgung (136) hat.

2. Vorrichtung nach Anspruch 1, darüber hinaus aufweisend eine Ausnehmung (110), die im Körper gegenüber der Dichtfläche ausgebildet ist, wobei die Ausnehmung (110) insbesondere im Wesentlichen U-förmig ist oder einen wesentlichen halbkreisförmigen Querschnitt in einem zur Längsachse des elastischen Rohrs orthogonalen Schnitt hat.

3. Vorrichtung nach Anspruch 2, wobei
das elastische Rohr (116) zumindest teilweise in der Ausnehmung angeordnet ist.

4. Vorrichtung nach einem der vorhergehenden Ansprüche, wobei die Dichtfläche (108) in der Substratöffnung (106) ausgebildet ist.

5. Vorrichtung nach einem der Ansprüche 2 bis 4, wobei
der Körper (104) mindestens eine Rohranbringungsöffnung (126) aufweist, welche die Ausnehmung in der Richtung der Längsachse (X) der Ausnehmung (110) verlängert, um mindestens ein Element anzubringen, das aus der Gruppe ausgewählt ist, die aus den elastischen Rohr und dem starren Stab besteht.

6. Vorrichtung nach Anspruch 5, wobei
die mindestens eine Rohranbringungsöffnung (126) eine umfängliche Rohranbringungsöffnungsdichtfläche (128) hat, wobei das elastische Rohr so gegen die Rohranbringungsöffnungsdichtfläche (128) gepresst ist, dass eine Fluidströmung in Richtung durch die mindestens eine Rohranbringungsöffnung verhindert ist, wobei insbesondere die Versorgungsöffnungsdichtfläche im Wesentlichen konisch ist.

7. Vorrichtung nach Anspruch 5 oder 6, darüber hinaus aufweisend mindestens einen Stopfen (130), der jeweils in einer Rohranbringungsöffnung angeordnet ist, wobei der Stopfen das elastische Rohr (116) gegen die Anbringungsöffnungsdichtfläche presst, wobei insbesondere der mindestens eine Stopfen im Wesentlichen konisch ist.

8. Vorrichtung nach Anspruch 7, wobei
der mindestens eine Stopfen den starren Stab (124) hält.

9. Substratbearbeitungsvorrichtung zum Bearbeiten eines flexiblen Substrats, wobei die Substratbearbeitungsvorrichtung umfasst
eine erste Kammer (12) und eine zweite Kammer (14), die von der ersten Kammer getrennt ist, und eine Vorrichtung nach einem der vorhergehenden Ansprüche, wobei
die Vorrichtung eine Fluidverbindung zwischen der ersten und der zweiten Kammer selektiv öffnet oder schließt.

10. Verfahren zum Zusammenbauen einer Vorrichtung zum Abdichten eines Kammereinlasses oder eines Kammerauslasses für ein flexibles Substrat (16), Folgendes umfassend
Bereitstellen eines Körpers (104) mit einer Dichtfläche (108), wobei eine Substratöffnung (106) im Körper ausgebildet ist, die dazu ausgelegt ist, vom flexiblen Substrat durchquert zu werden;
Einsetzen eines elastischen Rohrs (116) in den Körper, so dass das elastische Rohr (116) zumindest teilweise der Dichtfläche (108) zugewandt ist, wobei das elastische Rohr einen Anschlussabschnitt hat und dazu ausgelegt ist, sich während des Betriebs aufzublähen und zu entleeren,
Anordnen des elastischen Rohrs um einen starren Stab (124) herum, wobei es sich bei dem starren Stab (124) um ein starres Rohr handelt, wobei das elastische Rohr (116) mittels des starren Stabs (124) in einer festen Position in der Vorrichtung (100) gehalten wird, und Anschließen des inneren des starren Rohrs an eine Gasversorgung, so dass der Anschlussabschnitt des elastischen Rohrs an die Gasversorgung (136) angeschlossen wird.

11. Verfahren nach Anspruch 10, wobei
die Vorrichtung darüber hinaus eine Ausnehmung (110) aufweist, die im Körper gegenüber der Dichtfläche ausgebildet ist, wobei das Verfahren umfasst Einsetzen des elastischen Rohrs (116) zumindest teilweise in die Ausnehmung.

12. Verfahren nach Anspruch 11, wobei
der Körper mindestens eine Rohrzufuhröffnung (126) aufweist, welche die Ausnehmung in der Richtung ihrer Längsachse verlängert, wobei das elastische Rohr durch die Rohrzufuhröffnung in die Ausnehmung eingeführt wird.

13. Verfahren nach Anspruch 12, darüber hinaus umfassend Anpressen des elastischen Rohrs gegen eine umfängliche Rohrzufuhröffnungsdichtfläche (128) der mindestens einen Rohrzufuhröffnung, so dass eine Fluidströmung in Richtung durch die mindestens eine Rohrzufuhröffnung verhindert wird.

## Revendications

1. Dispositif (100) destiné à étanchéifier une entrée de chambre (18) ou une sortie de chambre pour un substrat flexible (16), comprenant un corps (104) présentant une surface d'étanchéité (108),
une ouverture de substrat (106) formée dans le corps et configurée pour être traversée par le substrat flexible,
un tube élastique (116) qui fait face au moins partiellement à la surface d'étanchéité, sachant que
le tube élastique est apte à gonfler et se dégonfler pendant le fonctionnement, une barre rigide (124) disposée à l'intérieur du tube élastique (116), sachant que la barre rigide (124) est un tube rigide,
sachant que le tube élastique (116) est maintenu par la barre rigide (124) dans une position fixe dans le dispositif (100), sachant que l'intérieur du tube rigide est configuré pour être raccordé à une alimentation en gaz,
et l'intérieur du tube rigide est en raccordement fluidique avec un espace entre le tube rigide et le tube élastique, de telle sorte que le tube élastique ait une partie de raccordement pour le raccordement de l'alimentation en gaz (136).

2. Le dispositif selon la revendication 1, comprenant en outre une cavité (110) formée dans le corps à l'opposé de la surface d'étanchéité, sachant que, en particulier, la cavité (110) est sensiblement en forme de U ou présente une section transversale sensiblement semi-circulaire dans une section perpendiculaire à un axe longitudinal du tube élastique.

3. Le dispositif selon la revendication 2, dans lequel
le tube élastique (116) est agencé au moins partiellement dans la cavité.

4. Le dispositif selon l'une des revendications précédentes, dans lequel la surface d'étanchéité (108) est formée dans l'ouverture de substrat (106).

5. Le dispositif selon l'une des revendications 2 à 4, dans lequel le corps (104) comprend au moins une ouverture de montage de tube (126) étendant la cavité dans la direction de l'axe longitudinal (X) de la cavité (110) pour le montage d'au moins un élément sélectionné dans le groupe constitué par le tube élastique et la barre rigide.

6. Le dispositif selon la revendication 5, dans lequel
l'au moins une ouverture de montage de tube (126) présente une surface d'étanchéité d'ouverture de montage de tube circonférentielle (128), sachant que le tube élastique est pressé contre la surface d'étanchéité d'ouverture de montage de tube (128) de sorte à éviter un flux de fluide en direction de traversée d'au moins une ouverture de montage de tube, sachant que, en particulier, la surface d'étanchéité d'ouverture d'alimentation est sensiblement conique.

7. Le dispositif selon la revendication 5 ou 6, comprenant en outre
au moins un bouchon (130) disposé respectivement dans une ouverture de montage de tube, sachant que le bouchon presse le tube élastique (116) contre la surface d'étanchéité d'ouverture de montage, sachant que, en particulier, l'au moins un bouchon est sensiblement conique.

8. Le dispositif selon la revendication 7, dans lequel
l'au moins un bouchon maintient la barre rigide (124).

9. Appareil de traitement de substrat destiné à traiter un substrat flexible, l'appareil de traitement de substrat comprenant
une première chambre (12) et une deuxième chambre (14) séparée de la première chambre, et
un dispositif selon l'une des revendications précédentes, sachant que le dispositif ouvre ou ferme sélectivement un raccord fluidique entre la première et la deuxième chambre.

10. Procédé destiné à assembler un dispositif destiné à étanchéifier une entrée de chambre ou une sortie de chambre pour un substrat flexible (16), comprenant la fourniture d'un corps (104) présentant une surface d'étanchéité (108), sachant qu'une ouverture de substrat (106) est formée dans le corps et configurée pour être traversée par le substrat flexible ;
l'insertion d'un tube élastique (116) dans le corps, de telle sorte que le tube élastique (116) fasse face au moins partiellement à la surface d'étanchéité (108), le tube élastique comportant une partie de raccordement et étant apte à gonfler et se dégonfler pendant le fonctionnement,
l'agencement du tube élastique autour d'une barre rigide (124), sachant que la barre rigide (124) est un tube rigide, sachant que le tube élastique (116) est maintenu par la barre rigide (124) dans une position fixe dans le dispositif (100), et le raccordement de l'intérieur du tube rigide à une alimentation en gaz de telle sorte que la partie de raccordement du tube élastique soit raccordée à l'alimentation en gaz (136).

11. Le procédé selon la revendication 10, dans lequel
le dispositif comprend en outre une cavité (110) formée dans le corps à l'opposé de la surface d'étanchéité, sachant que le procédé comprend l'insertion du tube élastique (116) au moins partiellement dans la cavité.

12. Le procédé selon la revendication 11, dans lequel
le corps comprend au moins une ouverture d'alimentation de tube (126) étendant la cavité en direction de son axe longitudinal, sachant que le tube élastique est introduit dans la cavité via l'ouverture d'alimentation de tube.

13. Le procédé selon la revendication 12, comprenant en outre
le fait de presser le tube élastique contre une surface d'étanchéité d'ouverture d'alimentation de tube (128) de l'au moins une ouverture d'alimentation de tube, de sorte à éviter un flux de fluide en direction de traversée d'au moins une ouverture d'alimentation de tube.
